# EUROPÄISCHE PATENTSCHRIFT

(11) **EP 1 623 057 B1**
(45) Veröffentlichungstag und Bekanntmachung des Hinweises auf die Patenterteilung: **15.10.2008**
(21) Anmeldenummer: 04732978.4
(22) Anmeldetag: 14.05.2004
(51) Int. Cl.: C25D 17/00

(54) **EINRICHTUNG ZUR BEHANDLUNG VON GEGENSTÄNDEN, INSBESONDERE GALVANISIERUNG FÜR LEITERPLATTEN**
DEVICE FOR TREATING OBJECTS, IN PARTICULAR FOR PLATING PRINTED CIRCUIT BOARDS
DISPOSITIF POUR TRAITER DES OBJETS, EN PARTICULIER POUR REALISER UN DEPOT ELECTROLYTIQUE SUR DES CARTES DE CIRCUITS IMPRIMES

(30) Priorität: 15.05.2003 DE 10323660
(43) Veröffentlichungstag der Anmeldung: 08.02.2006
(73) Patentinhaber: Gebr. Schmid GmbH & Co., D-72250 Freudenstadt (DE)
(72) Erfinder: SCHMID, Christian, 72250 Freudenstadt (DE)
(74) Vertreter: Ruff, Michael
(86) Internationale Anmeldenummer: PCT/EP2004/005227
(87) Internationale Veröffentlichungsnummer: WO 2004/101865

(56) Entgegenhaltungen:
- WO-A-03/038158
- US-A1- 2003 051 999

## Beschreibung

Die Erfindung betrifft eine Einrichtung gemäß dem Oberbegriff des Anspruchs 1 zur Behandlung von Gegenständen, insbesondere eine Galvanisiereinrichtung für Leiterplatten.

Eine entsprechende Galvanisiereinrichtung ist beispielsweise aus der EP 819 781 A1 bekannt. Dort sind Transporträder mit an der Außenseite angebrachten, teilweise schräg verlaufenden Kontaktsektoren beschrieben. Diese Kontaktsektoren dienen zur elektrischen Kontaktierung und Stromzuführung von einer Stromversorgung zu den Leiterplatten. Die Abschrägung hat den Sinn, dass der Übergang von einem Kontaktsektor zum nächsten gleitend und kontinuierlich erfolgt. Nachteilig ist hier jedoch, dass im wesentlichen stets ein linienförmiger elektrischer Kontakt besteht. Dies ist als nicht optimal anzusehen.

Die US 2003/051999 A1 beschreibt eine Vorrichtung zur elektrischen Kontaktierung von Leiterplatten. Dabei sind Kontaktwalzen vorgesehen, die an ihrer Oberfläche mit einem in sich elastisch ausgebildeten und elektrisch sehr gut leitfähigen Kontaktwerkstoff versehen sind. Somit werden also in sich elastische Kontaktelemente vorteilhaft aus Kunststoff oder Gummi beschrieben.

### Aufgabe und Lösung

Der Erfindung liegt die Aufgabe zugrunde, eine eingangs genannte Einrichtung zu schaffen, mit der die Nachteile des Standes der Technik vermieden werden können, insbesondere die elektrische Kontaktierung an Gegenstände wie Leiterplatten oder dergleichen verbessert werden kann.

Gelöst wird diese Aufgabe durch eine Einrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht:

Erfindungsgemäß werden die Gegenstände von Transportmitteln auf einer Durchlaufbahn durch eine Behandlungskammer der Einrichtung transportiert. Dabei laufen die Gegenstände in der Behandlungskammer durch ein Behandlungsmedium, beispielsweise eine Elektrolytlösung, in welche auf den Gegenstand aufzubringendes Material, beispielsweise Kupfer, gelöst ist. Es sind Kontaktiermittel vorgesehen, mit welchen die Gegenstände zur Stromzuführung von einer Stromversorgung elektrisch kontaktiert werden. Die Kontaktiermittel weisen mehrere Kontaktelemente auf, die elektrisch voneinander isoliert sind und im Behandlungsmedium zumindest teilweise umlaufen bzw. sich drehen.

Die Kontaktelemente sind dabei erfindungsgemäß elastisch oder gelenkig bewegbar an den Kontaktiermitteln angeordnet. Diese Anordnung ist derart, dass sie sich von einer Ausgangsstellung aus bewegen lassen zur Anpassung an verschiedene Oberflächen der Gegenstände einerseits. Andererseits kann es so ermöglicht werden, dass die Kontaktelemente beispielsweise an der Außenseite ebene Kontaktflächen aufweisen und mit diesen ebenen Kontaktoberflächen stets flächig auf ebene Gegenstände aufgedrückt werden. So ist zum einem nicht nur allgemein die elektrische Kontaktierung von den Kontaktiermitteln an die Gegenstände verbessert. Insbesondere die ebene Ausbildung von Kontaktoberflächen der Kontaktelemente mit der Möglichkeit, durch jeweils flächiges Andrücken an die Gegenstände eine gegenüber einem linienförmigen Kontakt stark vergrößerte Kontaktfläche zu schaffen, ist hier vorteilhaft.

Die Kontaktiermittel können derart ausgebildet sein, dass sie sich um eine Achse drehen bzw. eine tragende Drehachse oder Welle aufweisen. An dieser Drehachse können die Kontaktelemente angeordnet sein, wobei sie elastisch oder gelenkig bewegbar angeordnet sind. Diese elastische oder gelenkige Anordnung ist vorteilhaft derart ausgebildet, dass die Kontaktelemente um eine parallel zur Drehachse der Kontaktiermittel verlaufende Achse gedreht oder verschwenkt werden können. Diese Dreh- oder Verschwenkbewegung ist allerdings nicht zwangsläufig auf eine exakte Drehbewegung beschränkt. Es kann auch in etwa eine Drehbewegung sein, ohne feststehende exakte Drehachse. Ebenso kann es ein Verschwenken oder Neigen in Richtung der Drehachse sein, also um eine senkrecht zur Drehachse der Kontaktiermittel verlaufende Achse. So können sich die Kontaktelemente an alle möglichen Unebenheiten der Substrate anpassen.

Es ist von Vorteil, wenn die Kontaktelemente so breit sind, dass sie sich über einen Großteil oder sogar im wesentlichen die gesamte Breite der Kontaktiermittel erstrecken. Ihre Erstreckung kann im wesentlichen parallel zur Drehachse sein. Des weiteren kann vorteilhaft vorgesehen sein, dass die Kontaktoberflächen der Kontaktelemente rechteckig sind. Besonders vorteilhaft sind sie in Umfangsrichtung schmaler als in Drehachsenrichtung.

Es kann vorgesehen sein, dass ein trennender Spalt zwischen zwei benachbarten Kontaktelementen parallel zur Drehachse verläuft als Isolation. Durch die verbesserte Kontaktierung aufgrund der elastischen oder gelenkigen Anordnung der Kontaktelemente kann auf eine schräg überschneidende Ausbildung der Kontaktoberflächen gemäß der oben genannten EP 819 781 A1 verzichtet werden.

Vorteilhaft sind die Kontaktiermittel nach Art eines Rades, einer Rolle oder eine Walze ausgebildet. Sie drehen sich auf den Gegenständen und liegen dabei mit den Kontaktelementen daran an.

Eine Elastizität der Anordnung der Kontaktelemente an den Kontaktiermitteln ist vorteilhaft derart, dass bereits geringe Kräfte genügen, um eine elastische Bewegung, Drehung oder Schwenkung der Kontaktelemente gegenüber den Kontaktiermitteln bzw. deren Drehachse zu bewirken. Derartige geringe Kräfte können ein Drehmoment von wenigen Nm sein. So üben die Kontaktiermittel keinen allzu großen Druck auf die Gegenstände aus bei gleichzeitiger Bewirkung der Drehung oder Verschwenkung der Kontaktelemente.

Einerseits ist es möglich, dass die Kontaktelemente mittels einer länglichen Verbindung gegenüber einem Kern oder einer Drehachse der Kontaktiermittel mit einer elastischen Lagerung befestigt bzw. gelagert sind. Dabei kann die längliche Verbindung ein elastischer Stab sein. Dieser elastische Stab kann jeweils fest mit der Drehachse oder dem Kern der Kontaktiermittel einerseits und andererseits dem Kontaktelement verbunden sein. Die Bewegbarkeit der Kontaktelemente kann dabei ausschließlich durch die Elastizität der Verbindung erreicht werden. Anstelle eines Stabes kann ein Federelement verwendet werden, beispielsweise eine Spiralfeder, ein Kabel, eine Litze, ein Draht oder eine Blattfeder.

Des weiteren ist es möglich, dass die Kontaktelemente ein Drehgelenk aufweisen, welches vorteilhaft möglichst nahe an der Kontaktoberfläche liegt. So kann zwar eine Gelenkigkeit bzw. ein Verschwenken der Kontaktelemente bzw. der Kontaktoberflächen erreicht werden. Allerdings werden sie dabei nicht zu weit aus ihrer Grundposition heraus bewegt, was als vorteilhaft angesehen wird. Ein derartiges Drehgelenk kann eine Kugelpfanne an einem Kontaktelement vorsehen. In dieser Kugelpfanne kann ein Kugelkopf gelagert sein, welcher im wesentlichen starr mit der Drehachse oder einem Kern der Kontaktiermittel verbunden ist, beispielsweise über einen Abstandsstab.

Gemäß einer Variante der Erfindung kann vorgesehen sein, dass die Kontaktelemente in einen radähnlichen oder walzenähnlichen Rollenkörper eingebettet sind. Dabei stehen sie ein vorteilhaft Stück nach außen über den Rollenkörper über, insbesondere mit ihren Kontaktoberflächen. Hier kann vorgesehen sein, dass der Rollenkörper zumindest in einem äußeren Einbettungsbereich der Kontaktelemente, vorzugsweise insgesamt, die oben genannte Flexibilität und Elastizität aufweist. Dies kann durch einen Rollenkörper aus Kunststoff, Gummi, Elastomeren oder Schaumstoff erreicht werden, der eine geringe Härte oder Shore-Härte aufweisen sollte. Durch die Einbettung der Kontaktelemente in den Rollenkörper einerseits und dessen große Flexibilität und Elastizität andererseits sind die Kontaktelemente elastisch bewegbar oder verschwenkbar, wobei eine gewisse Rückstellkraft in eine Ausgangslage vorgesehen ist. Die Bewegbarkeit der Kontaktelemente ist vorteilhaft sowohl in radialer Richtung als auch bezüglich ihrer Ausrichtung gegeben, vorteilhaft bezüglich ihrer Ausrichtung um eine zur Drehachse der Kontaktiermittel parallele Achse.

Bei den vorgenannten Kontaktiermitteln mit Rollenkörpern aus zumindest teilweise sehr weichem Kunststoff oder entsprechendem Material kann es auch vorgesehen sein, dass diese mit einer im Verhältnis zu ihrer Härte derart großen Kraft gegen die Gegenstände gedrückt werden, dass sie eine deutlich von der kreisrunden Form abweichende, zumindest im Kontaktierbereich in etwa flach gedrückte Form aufweisen. So ist es bei ausreichend vielen Kontaktelementen an der Außenseite des Rollenkörpers möglich, stets mindestens ein oder mehrere Kontaktelemente an die Oberfläche der Gegenstände zu drücken.

Der Rollenkörper kann zur Erhöhung der Flexibilität oder Verschwenkbarkeit der Kontaktelemente zwischen den Kontaktelementen und der Drehachse oder einem Rollenkern eine Ausnehmung aufweisen. Sie kann auch als Verjüngung, Materialschwächung odgl. ausgeführt sein. Vorteilhaft liegt die Ausnehmung nahe an den Kontaktelementen. Die Ausnehmung kann auch in etwa einen Dreh- oder Verschwenkpunkt definieren.

Die Kontaktelemente können in einen solchen Rollenkörper eingegossen, eingespritzt oder eingeschäumt werden. Dies hängt von dem Material des Rollenkörpers ab, wobei es vorteilhaft weicher Kunststoff oder Schaumstoff ist.

Das Material des Rollenkörpers sollte elektrisch isolierend sein. So kann vorgesehen sein, dass das Material des Rollenkörpers in einen Spalt zwischen zwei Kontaktelementen reicht und so eine Isolierung bewirkt, die stets aufrechterhalten wird. Ein Spalt zwischen zwei Kontaktelementen kann in Umfangsrichtung gesehen relativ schmal sein. Es können wenige Millimeter sein, insbesondere ca. 1mm bis 2mm.

Um eine elektrisch leitfähige Verbindung zwischen den Kontaktelementen und einer Galvanisier-Einrichtung zu erreichen, können innerhalb der Kontaktiermittel Kontaktschienen oder dergleichen verlaufen. Diese wiederum können beispielsweise mit einer Drahtlitze an die Kontaktelemente reichen. Hier ist es des weiteren auch vorstellbar, eine Verbindung zwischen den Kontaktelementen und einer Drehachse oder einem Kern der Kontaktiermittel über metallische Federn, insbesondere Spiralfedern, zu erreichen. Diese ermöglichen eine Bewegbarkeit der Kontaktelemente zum einen in radialer Richtung und zum anderen eine Verschwenkbarkeit, insbesondere gegenüber benachbarten Kotaktelementen. Um hier jedoch noch eine gewisse Formstabilität der Kontaktiermittel nach Art eines Kontaktrades aufrechtzuerhalten, kann vorgesehen sein, dass benachbarte Kontaktelemente beispielsweise mit einer elastischen Verbindung zueinander, beispielsweise einem Gummiband, zusammengehalten werden. So wird kein Rollenkörper aus Vollmaterial odgl. benötigt.

Die Kontaktiermittel können derart ausgebildet sein, dass sie von einer Drehachse abgenommen werden können. Dabei können sie eine Baueinheit bilden. So können sie ersetzt oder gewartet werden. Auch die elektrische Verbindung ist vorteilhaft lösbar. Beispielsweise können für die elektrische Verbindung ein Stecker und eine entsprechende Steckerbuchse vorgesehen sein. Diese weisen vorzugsweise in die Richtung, mit welcher die Kontaktiermittel auf die Drehachse aufgeführt werden.

Die Kontaktiermittel können als Kontaktrolle ausgebildet sein mit einem Rollenkern, auf dem der Rollenkörper aus elastischem Material befestigt ist. Die Kontaktiermittel sind dabei in den Rollenkörper eingebettet und weisen eine eingebettete elektrische Verbindung, beispielsweise eine Drahtlitze, zu einem elektrischen Anschluss auf.

Bei einer Ausbildung der Kontaktiermittel mit mehreren Bereichen oder Schichten kann ein stabiler Kern vorgesehen sein. Mit diesem können die Kontaktelemente elastisch verbunden werden.

Für eine genauere Führung der Gegenstände sowie der Kontaktiermittel zu den Gegenständen, insbesondere bezüglich eines Abstands oder Anpressdrucks, kann vorgesehen sein, dass seitlich neben den Kontaktiermitteln eine konzentrisch angeordnete Auflagerolle läuft. Kontaktiermittel und Auflagerolle sind vorteilhaft fest miteinander verbunden und weisen eine gemeinsame Drehachse auf. Die Auflagerolle weist einen etwas geringeren Durchmesser auf als die Kontaktiermittel, so dass diese einen rund umlaufenden Überstand gegenüber der Auflagerolle besitzen. Im Betrieb liegen Kontaktiermittel und Auflagerolle auf einem Gegenstand auf. Durch die im wesentlichen starre Ausbildung der Auflagerolle werden die Kontaktiermittel mit den Kontaktelementen um das Maß des Überstands über die Auflagerolle zusammengedrückt bzw. gegen die Gegenstände gedrückt. Dabei liegt jeweils mindestens ein Kontaktelement während des Drehvorgangs flächig an einem Gegenstand auf.

Ein solcher Überstand kann wenige Millimeter betragen. Vorteilhaft liegt er zwischen 1mm und 2mm. Dies bedeutet, dass zwar an sich im wesentlichen jeder Punkt der Kontaktiermittel radial über die Auflagerolle übersteht. Allerdings sollte dieser Überstand nicht zu groß sein, um die notwendige Kraft zum Eindrücken der Kontaktiermittel nicht zu groß werden zu lassen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: eine Seitenansicht einer Kontaktrolle mit außen angeordneten Kontaktelementen, die in einem elastischen Rollenkörper eingebettet sind,
- Fig. 2: eine Ansicht der Kontaktrolle aus Fig. 1 von unten, wobei zwei Kontaktelemente auf eine Leiterplatte aufgedrückt sind flächig,
- Fig. 3: eine weitere Ausführung der Kontaktrolle aus Fig. 1 mit Kontaktelementen, die mittels einer Schraubenfeder mit einem Rollenkern verbunden sind,
- Fig. 4: eine weitere Abwandlung einer Kontaktrolle ähnlich Fig. 3, wobei die Schraubenfedern durch elastische Stäbe ersetzt sind und
- Fig. 5: eine weitere Abwandlung einer Kontaktrolle ähnlich Fig. 3 im Schnitt, wobei die Kontaktrolle von einer Achse abnehmbar ist.

### Detaillierte Beschreibung der Ausführungsbeispiele

Die Fig: 1 zeigt eine Seitenansicht einer Kontaktrolle 11 einer Galvanisiereinrichtung, mit welcher eine elektrische Kontaktierung an eine Leiterplatte 13 durchgeführt wird. Eine derartige prinzipielle elektrische Kontaktierung sowie eine Galvanisiereinrichtung, in welcher eine Kontaktrolle 11 eingesetzt werden kann, ist aus der vorgenannten EP 819 781 A1 bekannt. Deren Wortlaut wird diesbezüglich hiermit durch ausdrückliche Bezugnahme zum Inhalt dieser Beschreibung gemacht.

Die Kontaktrolle 11 weist vom Aufbau her einen Rollenkern 15 auf, der auch eine tragende Drehachse sein kann. Um diesen Rollenkern 15 herum ist ein Rollenkörper 17 aus weichem elastischen Material, beispielsweise Kunststoff in Schaumstoff-Form, angeordnet. Die Härte des Rollenkörpers 17 ist dabei derart gewählt, dass er sich ohne großen Kraftaufwand zumindest ein gewisses Stück eindrücken lässt. Vorteilhaft wird hierfür ein Schaumstoff mit geschlossenen Zellen verwendet, dessen Rückstellkräfte relativ groß sind, was zur Formstabilität der Kontaktrolle 11 beiträgt. Alternativ können Elastomere mit Aussparungen zur Erhöhung der Elastizität verwendet werden.

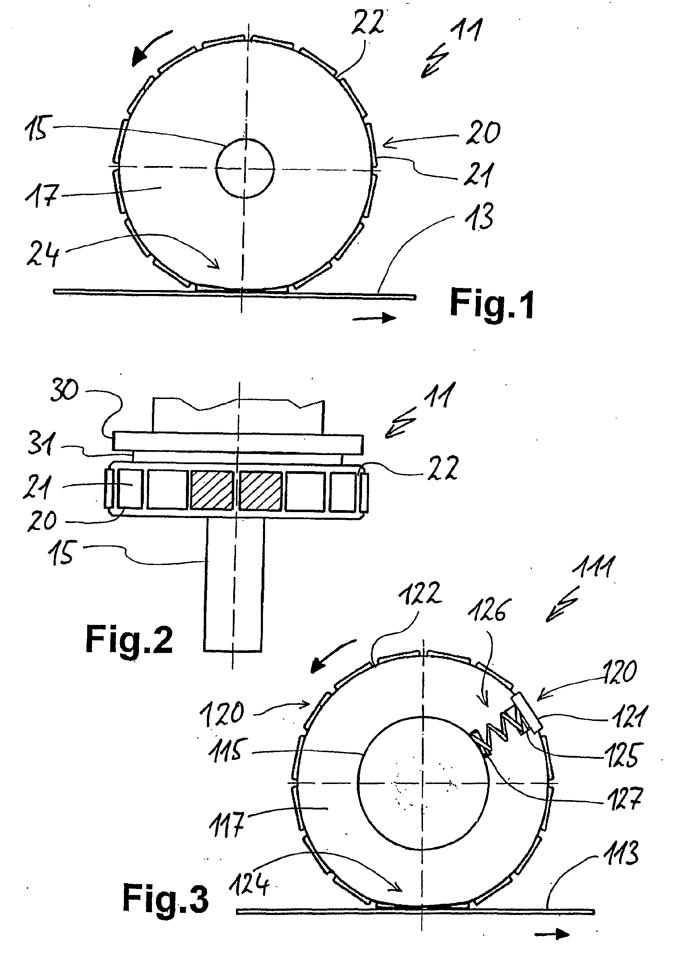

An der Außenseite der Kontaktrolle 11 sind Kontaktelemente 20 vorgesehen. Sie sind, was aus Fig. 2 zu erkennen ist, in etwa rechteckig ausgebildet und stehen mit den Kontaktoberflächen 21 ein Stück über den sonstigen Rollenkörper 17 über. Bei der Kontaktrolle 11 nach Fig. 1 und 2 sind sechzehn Kontaktelemente 20 vorgesehen, die jeweils identisch ausgebildet sind.

Die Kontaktelemente 20 sind zumindest ein Stück in den äußeren Bereich des Rollenkörpers 17 eingelassen, beispielsweise bei der Herstellung eingeschäumt. Dies bewirkt eine unlösbare Befestigung der Kontaktelemente 20 an dem Rollenkörper 17. Eine elektrische Kontaktierung von außerhalb zu den Kontaktelementen 20, beispielsweise durch eine Kommutator-Einrichtung an dem Rollenkern 15, ist nicht dargestellt, ist für den Fachmann jedoch grundsätzlich leicht auszubilden. Siehe hierzu auch die oben genannte EP 819 781 A1.

In Fig. 1 ist zu erkennen, wie der auf der Leiterplatte 13 aufliegende Bereich 24 der Kontaktrolle 11 etwas eingedrückt ist. Dies wird durch eine gewisse Auflagekraft bewirkt, welche eben genau so groß gewählt ist, dass dieses Zusammendrücken erfolgt. Die beiden Kontaktelemente 20, welche an dem zusammengedrückten Bereich 24 angeordnet sind, liegen mit ihrer vollen Kontaktoberfläche 21 an der Leiterplatte 13 an. Diese beiden Kontaktoberflächen 21 sind in der Fig. 2 schraffiert dargestellt. Durch diesen relativ großflächigen Kontakt erfolgt eine sichere und zuverlässige Kontaktierung an die Leiterplatte 13.

Wird die Kontaktrolle 11 ein Stück weiter gedreht, in Fig. 1 entgegen dem Uhrzeigersinn, so liegt, während das rechte der beiden Kontaktelemente 20 abhebt, bereits das links davon angeordnete zum Teil an der Leiterplatte 13 an. Jedenfalls liegt stets mindestens ein Kontaktelement 20 mit seiner vollen Kontaktoberfläche 21 an der Leiterplatte 13 an. Falls das Anliegen mehrerer Kontaktelemente aus bestimmten Gründen unbedingt gewünscht oder als nötig angesehen wird, können die Kontaktelemente auch schmaler ausgeführt werden.

Um eine genau definierte Auflage der Kontaktrolle 11 bzw. der Kontaktelemente 20 auf der Leiterplatte 13 zu erreichen, sollte der Abstand des Rollenkerns 15 zu der Leiterplatte stets derselbe sein. Dazu ist gemäß Fig. 2 seitlich neben der Kontaktrolle 11 eine Auflagerolle 30 vorgesehen, beispielsweise auf dem verlängerten Rollenkern 15 als Drehachse sitzend. Zwischen Auflagerolle 30 und Kontaktrolle 11 ist eine Abstandsscheibe 31 vorgesehen, welche zusätzlich isolierend sein sollte.

Es ist zu erkennen, wie weit die Kontaktrolle 11 bzw. die Kontaktoberflächen 21 über die Auflagerolle 30 radial überstehen. Wenn die Auflagerolle 30 stets voll auf der Leiterplatte 13 läuft, wird die Kontaktrolle 11 zusammengedrückt, wie in Fig. 1 zu erkennen ist.

Das Zusammendrücken der Kontaktrolle 11 in dem Bereich 24 bewirkt neben einem gewissen Kontaktdruck, dass die Kontaktelemente 20 sich mit ihren Kontaktoberflächen 21 flächig auf die Oberfläche der Leiterplatte 13 legen. Dazu verschwenken die Kontaktelemente 20 sozusagen um eine parallel zu dem Rollenkern 15 verlaufende Achse innerhalb ihrer Befestigung an dem Rollenkörper. Allerdings ist diese Verschwenkbewegung relativ kompliziert und mathematisch nur schwer zu beschreiben. Es kann jedoch gesagt werden, dass in der Regel ein Kontaktelement 20, sobald es mit einer seiner Kanten an der Leiterplatte 13 zu liegen kommt, gleich vollflächig auf die Kontaktoberfläche 21 aufdrückt.

Zwischen zwei Kontaktelementen 20 ist jeweils ein Isolierspalt 22 gegeben. Dieser kann mit Material des Rollenkörpers 17 gefüllt sein und so eine Isolierung zweier benachbarter Kontaktelemente gegeneinander bewirken.

Aus der Abwandlung einer Kontaktrolle 111 gemäß Fig. 3 ist zu erkennen, wie in einer Halterung 125 an der Innenseite eines Kontaktelements 120 eine Schraubenfeder 126 angebracht ist, welche auf den Rollenkern 115 zuläuft. Dort ist eine weitere Halterung 127 vorgesehen, in welcher das andere Ende der Schraubenfeder 126 befestigt ist. Vorteilhaft sind die Halterungen 125 und 127 sowie die Schraubenfeder 126 elektrisch leitfähig ausgebildet. So kann eine Kontaktierung an das Kontaktelement 120 erfolgen. Von der an sich feststehenden Halterung 127 am Rollenkern 115 kann eine Kontaktschiene oder ein Kontaktdraht weggeführt sein und auf sich bekannte Art und Weise mit einer Stromzuführung verbunden sein.

Eine derartige Schraubenfeder 126 dient neben einer elektrischen Kontaktierung auch dazu, eine gewisse Halterung des Kontaktelements 120 am Rollenkern 115 zu bewirken. Hier kann auch beispielsweise vorgesehen sein, in einer Abwandlung keinen massiven Rollenkörper 117 zu verwenden, sondern die Kontaktelemente 120 lediglich mit Schraubenfedern 126 am Rollenkern 115 zu befestigen. Des weiteren können nach Art eines umlaufenden flexiblen Bandes benachbarte Kontaktelemente 120 jeweils so miteinander verbunden sein, dass ihr Abstand zueinander eingehalten wird. Ansonsten kann die Verbindung zweier benachbarter Kontaktelemente 120 jedoch elastisch und gelenkig beweglich sein. Dies entspricht dann in etwa einem Speichenrad, wobei die Speichen durch die elastischen Schraubenfedern 126 gebildet werden. Das Speichenrad hätte einen Aufbau derart, dass der jeweils auf der Leiterplatte 113 aufliegende Bereich etwas eingedrückt werden kann, wodurch eine vollflächige Auflage jeweils mindestens eines Kontaktelementes gewährleistet ist. Zur Verbindung zweier benachbarter Kontaktelemente 120 bzw. als kompletter Kreisschluss kann ein umlaufendes Band oder ein umlaufender elastischer Stab oder dergleichen vorgesehen sein.

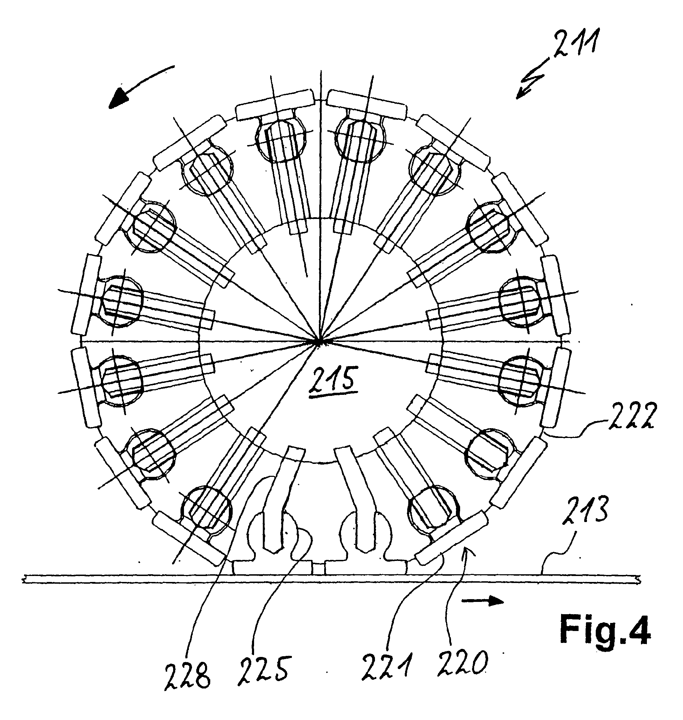

In Fig. 4 ist eine weitere Abwandlung dargestellt. Hier sind die Schraubenfedern 126 aus Fig. 3 ersetzt durch elastische Stäbe 228. Diese sind einerseits in Halterungen 225 an der Innenseite der Kontaktelemente 220, und andererseits in bohrungsartigen Halterungen 227 in einem Rollenkern 215 befestigt.

Die elastischen Stäbe 228 können, wie zuvor in Fig. 3 für die Schraubenfeder beschrieben, entweder alleine oder in Verbindung mit einem massiven Rollenkörper 217 vorgesehen sein. Eine elektrische Kontaktierung ist hier nicht dargestellt. Sie könnte einerseits durch ein elektrisch leitfähiges Material der Stäbe 228 erreicht werden. Alternativ können die Stäbe von metallischen Schraubenfedern umgeben sein oder Anschlussdrähte aufweisen.

Aus Fig. 4 ist zu erkennen, wie bei den unteren Kontaktelementen 220, welche mit ihrer Kontaktoberfläche 221 vollflächig auf der Leiterplatte 213 aufliegen, die jeweiligen elastischen Stäbe 228 verbogen oder abgeknickt sind.

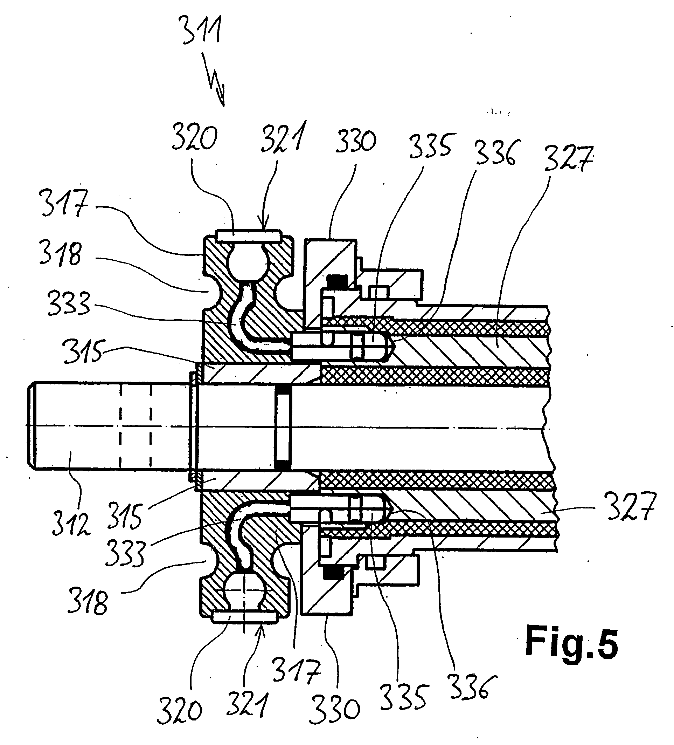

Fig. 5 zeigt im Schnitt eine weitere Ausbildung einer erfindungsgemäßen Kontakteinrichtung bzw. Kontaktrolle 311. Ähnlich derjenigen aus Fig. 1 oder 2 sind die Kontaktelemente 320 in einen elastischen Rollenkörper 317, beispielsweise aus weichem Material oder Schaumstoff, eingebettet. Der Rollenkörper 317 weist dabei radial innerhalb der Kontaktelemente 320 eine Verengung 318 auf. Diese dient zur Erhöhung der Flexibilität des äußeren Endes des Rollenkörpers 317 und somit zur besseren Verschwenkbarkeit oder Verdrehbarkeit der Kontaktelemente 320.

Der Rollenkörper 317 ist auf einen ringförmigen Rollenkern 315 aufgebracht, vorteilhaft unlösbar. Zusammen mit dem Rollenkern 315 wiederum kann die Kontaktrolle 311 auf eine Achse 312 aufgesteckt und mechanisch befestigt werden, beispielsweise durch einen Federring.

Innerhalb des Rollenkörpers 317 verläuft ein Zuleitungsdraht 333. Er mündet in Stecker 335, die in Richtung der Achse 312 weisen. Die Stecker 335 wiederum werden in entsprechende Steckbuchsen 336 in Kontaktschienen 327 eingesteckt. So erfolgt die elektrische Kontaktierung zwischen den verschiedenen Kontaktschienen 327 und den Kontaktelementen 320.

Dies bedeutet, dass die Kontaktrolle 311 abgezogen und repariert oder ausgetauscht werden kann. Des weiteren befindet sich auf der Achse 312 eine Auflagerolle 330, welche beim Abziehen der Kontaktrolle 311 auf der Achse verbleibt. Die Trennung erfolgt also zwischen Kontaktrolle 311 bzw. rechter Seite des Rollenkörpers 317 und der Auflagerolle 330.

Die Steckverbindung zwischen den Steckern 335 und den Steckbuchsen 336 kann dabei auch derart rastend oder klemmend ausgebildet sein, dass sie für eine sichere Befestigung der Kontaktrolle 311 auf der Achse 312 sorgt.

Um eine sichere Befestigung und Ausrichtung der länglichen Stecker 335 an dem Rollenkörper 317 bzw. der Kontaktrolle 311 zu gewährleisten, kann der Rollenkern 315 aus Kunststoff gefertigt sein und ein Stecker 335 daran befestigt werden, beispielsweise verklebt oder verschraubt.

Zur Aufteilung der elektrischen Kontaktierung an die einzelnen Kontaktelemente 320 ist es möglich, einen Stecker 335 mit zwei Zuleitungsdrähten 333 zu zwei Kontaktelementen 320 zu versehen. Auf diese Art und Weise werden immer zwei Kontaktelemente 320 gleichzeitig auf dieselbe Art und Weise elektrisch kontaktiert. Unter Inkaufnahme des größeren Aufwandes ist es ebenso möglich, pro Kontaktelement 320 einen Zuleitungsdraht 333 und einen Stecker 335 vorzusehen.

In einer weiteren, nicht dargestellten Ausbildung ist es möglich, als Befestigung der Kontaktelemente im wesentlichen starre Stäbe vorzusehen, welche von einem Rollenkern abstehen. An deren Ende kann ein Kugelkopf angeordnet sein. Die Kontaktelemente weisen eine passende Kugelpfanne auf, welche möglichst nahe an den Kontaktoberflächen liegen sollte. Sitzen die Kontaktelemente mit den Kugelpfannen auf den Kugelköpfen der Haltestäbe, so können sie direkt gelenkig verschwenkt werden. Dabei kann zusätzlich, entweder in einer Gelenkaufnahme oder in dem verbindenden Stab, eine gewisse Längenveränderbarkeit in radialer Richtung vorgesehen sein. Diese bewirkt ein verbessertes Laufverhalten der Kontaktrolle auf der Leiterplatte beim Abrollen.

Die Wahl verschiedener Materialien für die Kontaktelemente sowie jeweils elektrische Ansteuermöglichkeiten gehen aus dem vorgenannten Stand der Technik hervor und können entsprechend auch hier angewendet werden.

## Patentansprüche

1. Einrichtung zur Behandlung von Gegenständen, insbesondere Galvanisiereinrichtung für Leiterplatten (13, 113, 213), auf einer Durchlaufbahn durch eine Behandlungskammer mit einem Behandlungsmedium, wie eine Elektrolytlösung, mit Transportmitteln für den Transport der Gegenstände durch die Behandlungskammer und mit Kontaktiermitteln (11, 111, 211, 311) zur elektrischen Kontaktierung und Stromzuführung von einer Stromversorgung zu den Gegenständen, wobei die Kontaktiermittel mehrere elektrisch voneinander isolierte und auf einem Gegenstand aufliegend umlaufende Kontaktelemente (20, 120, 220, 320) aufweisen, **dadurch gekennzeichnet, dass** die Kontaktelemente elastisch oder gelenkig bewegbar an den Kontaktiermitteln (11, 111, 211, 311) angeordnet sind.

2. Einrichtung nach Anspruch 1, **dadurch gekennzeichnet, dass** die Kontaktiermittel (11, 111, 211, 311) eine Drehachse (15, 115, 215, 312) aufweisen, an der die Kontaktelemente (20, 120, 220, 320) elastisch oder gelenkig bewegbar angeordnet sind.

3. Einrichtung nach Anspruch 1 oder 2, **dadurch gekennzeichnet, dass** die Kontaktelemente (20, 120, 220, 320) derart elastisch oder gelenkig angeordnet sind, dass sie drehbar oder verschwenkbar sind zumindest um eine Achse, welche parallel zur Drehachse (15, 115, 215, 312) der Kontaktiermittel (11, 111, 211, 311) verläuft.

4. Einrichtung nach einem der vorhergehenden Ansprüche, **dadurch gekennzeichnet, dass** die Kontaktelemente (20, 120, 220, 320) an der Außenseite ebene Kontaktoberflächen (21, 121, 221, 321) aufweisen.

5. Einrichtung nach einem der vorhergehenden Ansprüche, **dadurch gekennzeichnet, dass** sich die Kontaktelemente (20, 120, 220, 320) über einen Großteil der Breite der Kontaktiermittel (11, 111, 211, 311) erstrecken, vorzugsweise im wesentlichen parallel zur Drehachse (15, 115, 215, 312) verlaufen.

6. Einrichtung nach Anspruch 2, **dadurch gekennzeichnet, dass** die Kontaktelemente (120, 220) mittels einer länglichen Verbindung (126, 228) gegenüber der Drehachse (115, 215) elastisch daran gelagert sind, wobei vorzugsweise die längliche Verbindung ein elastischer Stab (228) ist und jeweils im wesentlichen fest mit der Drehachse und dem Kontaktelement verbunden ist.

7. Einrichtung nach einem der Ansprüche 1 bis 5, **dadurch gekennzeichnet, dass** die Kontaktelemente (20, 120, 220) ein Drehgelenk aufweisen, vorzugsweise nahe an einer äußeren Kontaktoberfläche (21, 121, 221), wobei insbesondere die Kontaktelemente eine Kugelpfanne aufweisen, in welcher ein Kugelkopf gelagert ist, welcher im wesentlichen starr mit der Drehachse (15, 115, 215) verbunden ist.

8. Einrichtung nach einem der Ansprüche 1 bis 5, **dadurch gekennzeichnet, dass** die Kontaktelemente (20, 120, 220, 320) in einen Rollenkörper (17, 117, 317) eingebettet sind, der zumindest in diesem äußeren Einbettungs-Bereich flexibel und elastisch ist, vorzugsweise mit geringer Härte oder Shore-Härte, wobei die Kontaktelemente mittels der Einbettung in den Rollenkörper elastisch bewegbar bzw. verschwenkbar sind mit einer gewissen Rückstellkraft.

9. Einrichtung nach Anspruch 8, **dadurch gekennzeichnet, dass** der Rollenkörper (317) zwischen den Kontaktelementen (320) und der Drehachse (312) oder einem Rollenkern (315) eine Ausnehmung (318) aufweist zur Erhöhung der Flexibilität oder Verschwenkbarkeit der Kontaktelemente, wobei vorzugsweise die Ausnehmung nahe an den Kontaktelementen liegt.

10. Einrichtung nach Anspruch 8 oder 9, **dadurch gekennzeichnet, dass** die Kontaktelemente (20, 120, 220, 320) in den Rollenkörper (17, 117, 317) eingegossen, eingespritzt oder eingeschäumt sind.

11. Einrichtung nach einem der Ansprüche 8 bis 10, **dadurch gekennzeichnet, dass** die Einbettung in den Rollenkörper (17, 117, 317) derart ist, dass in einem Spalt (22, 122, 222) zwischen zwei Kontaktelementen (20, 120, 220, 320) zumindest teilweise, vorzugsweise bis kurz vor dem Außendurchmesser, elastisches flexibles Rollenmaterial vorhanden ist.

12. Einrichtung nach einem der vorhergehenden Ansprüche, **dadurch gekennzeichnet, dass** ein Spalt (22, 122, 222) zwischen zwei Kontaktelementen (20, 120, 220, 320) in Umfangsrichtung schmal ist, insbesondere ca. 2mm schmal ist.

13. Einrichtung nach einem der vorhergehenden Ansprüche, **dadurch gekennzeichnet, dass** eine Elastizität der Anordnung der Kontaktelemente (20, 120, 220, 320) an den Kontaktiermitteln (11, 111, 211, 311) derart ist, dass geringe Kräfte oder Drehmomente genügen zur elastischen Bewegung oder Drehung oder Schwenkung der Kontaktelemente gegenüber der Drehachse (15, 115, 215, 312), vorzugsweise mit einer Kraft von wenigen N oder mit einem Drehmoment von wenigen Nm.

14. Einrichtung nach einem der vorhergehenden Ansprüche, **dadurch gekennzeichnet, dass** eine elektrische leitfähige Verbindung (126, 333) zwischen einem Kontaktelement (20, 120, 220, 320) und einer Kontaktschiene (127, 327) innerhalb der Kontaktiermittel (11, 111, 211, 311) flexibel ausgebildet ist, vorzugsweise eine Drahtlitze ist.

15. Einrichtung nach einem der vorhergehenden Ansprüche, **dadurch gekennzeichnet, dass** die Kontaktiermittel (311) von einer Drehachse (312) abnehmbar sind, vorzugsweise als eine Baueinheit, wobei insbesondere auch die elektrische Verbindung (335, 336) lösbar ist.

16. Einrichtung nach Anspruch 15, **dadurch gekennzeichnet, dass** die Kontaktiermittel (311) als Kontaktrolle ausgebildet sind mit einem Rollenkern (315), auf dem der Rollenkörper (317) aus elastischem Material befestigt ist, wobei die Kontaktiermittel (311) in den Rollenkörper eingebettet sind und eine eingebettete elektrische Verbindung (333) zu einem elektrischen Anschluss aufweisen.

17. Einrichtung nach Anspruch 15 oder 16, **dadurch gekennzeichnet, dass** für die elektrische Verbindung Stecker (335) und entsprechende Steckerbuchsen (336) vorgesehen sind, die vorzugsweise in die Richtung weisen, mit welcher die Kontaktiermittel (311) auf die Drehachse (312) aufgeführt werden.

18. Einrichtung nach einem der vorhergehenden Ansprüche, **dadurch gekennzeichnet, dass** ein stabiler Kern (15, 115, 215, 315) der Kontaktiermittel (11, 111, 211, 311) vollständig mit dem elastischen und aus weichem Material bestehenden Rollenkörper (17, 117, 217, 317) umgeben ist.

19. Einrichtung nach einem der vorhergehenden Ansprüche, **dadurch gekennzeichnet, dass** seitlich neben den Kontaktiermitteln (11, 111, 211, 311) und konzentrisch dazu eine starre Auflagerolle (30, 330) angeordnet ist, wobei vorzugsweise Kontaktiermittel und Auflagerolle fest miteinander verbunden sind, wobei die Auflagerolle einen etwas geringeren Durchmesser aufweist als die Kontaktiermittel und im Betrieb auf einem Gegenstand (13, 113, 213) aufliegt derart, dass die Kontaktiermittel um den Überstand über die Auflagerolle (30, 330) zusammengedrückt werden mit flächiger Auflage jeweils mindestens eines Kontaktelements (20, 120, 220, 320) während des Drehvorgangs.

20. Einrichtung nach Anspruch 19, **dadurch gekennzeichnet, dass** der Überstand wenige mm beträgt, vorzugsweise zwischen 1 mm und 2 mm.

## Claims

1. Device for treating objects, particularly plating device for printed circuit boards (13, 113, 213) on a continuous path through a treatment chamber with a treatment medium, such as an electrolytic solution, with conveying means for conveying the objects through the treatment chamber and with contacting means (11, 111, 211, 311) for electrical contacting and the supply of power from a power supply to the objects, the contacting means having several electrically mutually insulated, circumferential contact elements (20, 120, 220, 320) engaging on an object, **characterized in that** the contact elements are placed elastically or in articulated movable manner on contacting means (11, 111, 211, 311).

2. Device according to claim 1, **characterized in that** the contacting means (11, 111, 211, 311) have a fulcrum (15, 115, 215, 312) on which the contact elements (20, 120, 220, 320) are placed elastically or in articulated movable manner.

3. Device according to claim 1 or 2, **characterized in that** the contact elements (20, 120, 220, 320) are so arranged in elastic or articulated manner that they are rotatable or pivotable at least about an axis running parallel to the fulcrum (15, 115, 215, 312) of contacting means (11, 111, 211,311).

4. Device according to one of the preceding claims, **characterized in that** the contact elements (20, 120, 220, 320) are provided on the outside with planar contact surfaces (21, 121, 221, 321).

5. Device according to one of the preceding claims, **characterized in that** the contact elements (20, 120, 220, 320) extend over most of the width of contacting means (11, 111, 211, 311), preferably running substantially parallel to the fulcrum (15, 115, 215, 312).

6. Device according to claim 2, **characterized in that** the contact elements (120, 220) by means of an elongated connection (126, 228) with respect to fulcrum (115, 215) are elastically mounted on the latter and preferably the elongated connection is an elastic bar (228) and is in each case connected substantially fixed to the fulcrum and contact element.

7. Device according to one of the claims 1 to 5, **characterized in that** the contact elements (20, 120, 220) have a pivot joint, preferably close to an outer contact surface (21, 121, 221) and in particular the contact elements have a ball cup in which is mounted a ball end, which is connected substantially rigid to the fulcrum (15, 115, 215).

8. Device according to one of the claims 1 to 5, **characterized in that** the contact elements (20, 120, 220, 320) are embedded in a roller body (17, 117, 317) which is flexible and elastic at least in said outer embedding area, preferably with a low hardness or Shore hardness, as a result of the embedding in the roller body the contact elements being elastically movable or pivotable with a certain resiliency.

9. Device according to claim 8, **characterized in that** the roller body (317) is provided between contact elements (320) and fulcrum (312) or a roller core (315) with a recess (318) for increasing the flexibility or pivotability of the contact elements and preferably the recess is close to the contact elements.

10. Device according to claim 8 or 9, **characterized in that** the contact elements (20, 120, 220, 320) are cast, injection moulded or foamed into the roller body (17, 117, 317).

11. Device according to one of the claims 8 to 10, **characterized in that** the embedding in roller body (17, 117, 317) is such that between two contact elements (20, 120, 220, 320), at least partly and preferably to just short of the external diameter, elastic flexible roller material is present in a gap (22, 122, 222).

12. Device according to one of the preceding claims, **characterized in that** a gap (22, 122, 222) between two contact elements (20, 120, 220, 320) is circumferentially narrow, particularly approximately 2 mm.

13. Device according to one of the preceding claims, **characterized in that** elasticity of the arrangement of the contact elements (20, 120, 220, 320) on contacting means (11, 111, 211, 311) is such that limited forces or torques are sufficient for the elastic movement or rotation or pivoting of the contact elements relative to fulcrum (15, 115, 215, 312), preferably with a force of a few N or a torque of a few Nm.

14. Device according to one of the preceding claims, **characterized in that** an electrically conductive connection (126, 333) between a contact element (20, 120, 220, 320) and a contact bar (126, 327) within the contacting means (11, 111, 211, 311) has a flexible construction and is preferably a stranded wire.

15. Device according to one of the preceding claims, **characterized in that** the contacting means (311) can be removed from a fulcrum (312), preferably as a subassembly and in particular the electrical connection (335, 336) is also detachable.

16. Device according to claim 15, **characterized in that** the contacting means (311) are constructed as a contact roller with a roller core (315) to which is fixed the elastic material roller body (317), the contacting means (311) being embedded in the roller body and have an embedded, electrical connection (33) to an electrical terminal.

17. Device according to claim 15 or 16, **characterized in that** for the electrical connection plugs (335) and corresponding sockets (336) are provided, which are preferably directed in a direction in which the contacting means (311) run on fulcrum (312).

18. Device according to one of the preceding claims, **characterized in that** a stable core (15, 115, 215, 315) of contacting means (11, 111, 211, 311) is completely surrounded with the elastic, flexible material roller body (17, 117, 217, 317).

19. Device according to one of the preceding claims, **characterized in that** laterally alongside and concentric to contacting means (11, 111, 211, 311) is provided a rigid bearing roller (30, 330), the contacting means and bearing roller being preferably firmly interconnected, the bearing roller having a somewhat smaller diameter than the contacting means and in operation rests on an object (13, 113, 213) in such a way that the contacting means are compressed by the projection length over the bearing roller (30, 330) with flat engagement of in each case at least one contact element (20, 120, 220, 320) during the turning process.

20. Device according to claim 19, **characterized in that** the projection length is a few mm, preferably between 1 and 2 mm.

## Revendications

1. Dispositif pour le traitement d'objets, notamment dispositif de galvanisation pour des cartes de circuit imprimé (13, 113, 213), sur un parcours en continu à travers une chambre de traitement avec une substance de traitement, comme une solution électrolytique, avec des dispositifs de transport pour le transport des objets à travers la chambre de traitement et avec des dispositifs de connexion (11, 111, 211, 311) pour le branchement électrique et l'amenée de courant aux objets à partir d'une alimentation en courant, sachant que les dispositifs de connexion présentent sur tout le pourtour plusieurs éléments de contact (20, 120, 220, 320) électriquement isolés les uns par rapport aux autres et adjacents à un objet, **caractérisé en ce que** les éléments de contact sont disposés sur les dispositifs de connexion (11, 111, 211, 311) en étant movibles de manière élastique ou articulée.

2. Dispositif d'après la revendication 1, **caractérisé en ce que** les dispositifs de connexion (11, 111, 211, 311) présentent un axe de rotation (15, 115, 215, 312) sur lequel sont disposés les éléments de contact (20, 120, 220, 320) en étant movibles de manière élastique ou articulée.

3. Dispositif d'après la revendication 1 ou 2, **caractérisé en ce que** les éléments de contact (20, 120, 220, 320) sont disposés en étant movibles de façon élastique ou articulée de manière à être rotatifs ou pivotables au moins autour d'un axe parallèle à l'axe de rotation (15, 115, 215, 312) des dispositifs de connexion (11, 111, 211, 311).

4. Dispositif d'après une des revendications précédentes, **caractérisé en ce que** les éléments de contact (20, 120, 220, 320) présentent à la face extérieure des surfaces de contact (21, 121, 221, 321) planes.

5. Dispositif d'après une des revendications précédentes, **caractérisé en ce que** les éléments de contact (20, 120, 220, 320) s'étendent sur la plus grande partie de la largeur des dispositifs de connexion (11, 111, 211, 311), de préférence de manière essentiellement parallèle à l'axe de rotation (15, 115, 215, 312).

6. Dispositif d'après la revendication 2, **caractérisé en ce que** les éléments de contact (120, 220) sont logés au moyen d'un raccord (126, 228) oblong à l'axe de rotation (115, 215) de manière élastique par rapport à celui-ci, sachant que de préférence le raccord oblong est une tige élastique (228) qui est raccordée respectivement de manière essentiellement fixe à l'axe de rotation et à l'élément de contact.

7. Dispositif d'après une des revendications de 1 à 5, **caractérisé en ce que** les éléments de contact (20, 120, 220) présentent une articulation tournante, de préférence à proximité d'une surface de contact extérieure (21, 121, 221), sachant que notamment les éléments de contact présentent un logement de rotule, dans lequel est logée une tête sphérique, qui est raccordée de manière essentiellement rigide à l'axe de rotation (15, 115, 215).

8. Dispositif d'après une des revendications de 1 à 5, **caractérisé en ce que** les éléments de contact (20, 120, 220, 320) sont incorporés dans un corps de rouleau (17, 117, 317) flexible et élastique au moins dans son domaine extérieur d'incorporation, de préférence à faible dureté ou dureté Shore, sachant que, grâce à l'incorporation dans le corps de rouleau, les éléments de contact sont élastiquement déplaçables ou encore pivotables avec une certaine force de rappel.

9. Dispositif d'après la revendication 8, **caractérisé en ce que** le corps de rouleau (317) présente un évidement (318) entre les éléments de contact (320) et l'axe de rotation (312) ou le noyau de rouleau (315) pour agrandir la flexibilité ou la pivotabilité des éléments de contact, sachant que de préférence l'évidement se trouve à proximité des éléments de contact.

10. Dispositif d'après la revendication 8 ou 9, **caractérisé en ce que** les éléments de contact (20, 120, 220, 320) sont coulés, insérés par injection ou insérés par moussage dans le corps de rouleau (17, 117, 317).

11. Dispositif d'après une des revendications de 8 à 10, **caractérisé en ce que** l'incorporation dans le corps de rouleau (17, 117, 317) est tel que dans un interstice (22, 122, 222) entre deux éléments de contact (20, 120, 220, 320) on trouve au moins en partie du matériau flexible de rouleau, de préférence presque jusqu'au diamètre extérieur.

12. Dispositif d'après une des revendications précédentes, **caractérisé en ce qu'**un interstice (22, 122, 222) entre deux éléments de contact (20, 120, 220, 320) est étroit en direction de circonférence, en présentant notamment une valeur d'à peu près 2 mm.

13. Dispositif d'après une des revendications précédentes, **caractérisé en ce qu'**une élasticité de l'arrangement des éléments de contact (20, 120, 220, 320) sur les dispositifs de connexion (11, 111, 211, 311) est telle que des forces ou des couples faibles suffisent pour réaliser un mouvement élastique ou une rotation élastique ou un pivotement élastique des éléments de contact par rapport à l'axe de rotation (15, 115, 215, 312), de préférence la force ne présentant que quelques N ou le couple ne présentant que quelques Nm.

14. Dispositif d'après une des revendications précédentes, **caractérisé en ce qu'**un raccord (126, 333) électriquement conductible entre un élément de contact (20, 120, 220, 320) et un rail de contact (127, 327) à l'intérieur des dispositifs de connexion (11, 111, 211, 311) est réalisé de façon flexible, en étant de préférence un fil électrique souple.

15. Dispositif d'après une des revendications précédentes, **caractérisé en ce que** les dispositifs de connexion (311) sont détachables d'un axe de rotation (312), de préférence en tant qu'unité de construction, sachant que notamment le raccord électrique (335, 336) est également détachable.

16. Dispositif d'après la revendication 15, **caractérisé en ce que** les dispositifs de connexion (311) sont réalisés comme rouleau de contact, avec un noyau de rouleau (315) sur lequel est fixé le corps de rouleau (317) en un matériau élastique, sachant que les dispositifs de connexion (311) sont incorporés dans le corps de rouleau et qu'ils présentent un raccordement électrique (333) incorporé, à une prise électrique.

17. Dispositif d'après la revendication 15 ou 16, **caractérisé en ce que** pour effectuer le raccordement électrique on prévoit des prises mâles (335) et des prises femelles (336) correspondantes, qui sont orientées dans une direction qui correspond de préférence à celle du placement des dispositifs de connexion (311) sur l'axe de rotation (312).

18. Dispositif d'après une des revendications précédentes, **caractérisé en ce qu'**un noyau solide (15, 115, 215, 315) des dispositifs de connexion (11, 111, 211, 311) est entouré entièrement d'un corps de rouleau (17, 117, 217, 317) élastique, composé d'un matériau souple.

19. Dispositif d'après une des revendications précédentes, **caractérisé en ce qu'**un rouleau de support (30, 330) rigide est disposé latéralement auprès des dispositifs de connexion (11, 111, 211, 311) et de manière concentrique par rapport à ceux-ci, sachant que le rouleau de support est raccordé de manière fixe aux dispositifs de connexion, sachant que le rouleau de support présente un diamètre légèrement inférieur à celui des dispositifs de connexion, et qu'en service il est posé sur un objet (13, 113, 213) de manière que les dispositifs de connexion soient comprimés d'une mesure correspondant à leur partie qui dépasse le rouleau de support, la surface d'appui d'au moins un élément de contact (20, 120, 220, 320) étant respectivement plane pendant la rotation.

20. Dispositif d'après la revendication 19, **caractérisé en ce que** la partie en saillie comporte seulement quelques mm, de préférence entre 1 mm et 2 mm.
